Europäisches Patentamt

European Patent Office

Office européen des brevets

(19)

(11) **EP 1 345 241 A1**

(12) **EUROPEAN PATENT APPLICATION**
published in accordance with Art. 158(3) EPC

(43) Date of publication:
**17.09.2003 Bulletin 2003/38**

(51) Int Cl.⁷: **H01B 17/60**, B32B 5/28,
H01L 23/14

(21) Application number: **01997819.6**

(22) Date of filing: **26.11.2001**

(86) International application number:
**PCT/JP01/10290**

(87) International publication number:
**WO 02/043081 (30.05.2002 Gazette 2002/22)**

(84) Designated Contracting States:
**AT BE CH CY DE DK ES FI FR GB GR IE IT LI LU
MC NL PT SE TR**

(30) Priority: **27.11.2000 JP 2000359582**

(71) Applicant: **Daikin Industries, Ltd.
Osaka-shi, Osaka 530-8323 (JP)**

(72) Inventors:
 • **YAMAMOTO, Katsutoshi,
 c/o Yodogawa Works of DAIKIN
 Settsu-shi, Osaka 566-8585 (JP)**
 • **YAMAMOTO, Seigo,
 c/o Yodogawa Works of DAIKIN IND.
 Settsu-shi, Osaka 566-8585 (JP)**

 • **CHAEN, Shinichi,
 c/o Yodogawa Works of DAIKIN IND.
 Settsu-shi, Osaka 566-8585 (JP)**
 • **ASANO, Jun,
 c/o Yodogawa Works of DAIKIN IND. LTD.
 Settsu-shi, Osaka 566-8585 (JP)**
 • **KONISHI, Tomohisa, c/o Yodogawa Works of
 Settsu-shi, Osaka 566-8585 (JP)**

(74) Representative: **HOFFMANN EITLE
Patent- und Rechtsanwälte
Arabellastrasse 4
81925 München (DE)**

(54) **ELECTRICAL INSULATING PLATE, PREPREG LAMINATE AND METHOD FOR PRODUCING THEM**

(57)     This electrical insulating board 1 comprises a cloth substrate 3 and web layers 5. The web layers 5 made of fluororesin fibers and are stacked on both sides of the cloth substrate 3 and bonded there by entangling. In addition, to at least one side surface of web layers 5, heat treatment at a temperature of melting point of fluororesin fiber or more is applied under pressure.

Fig. 1

EP 1 345 241 A1

**Description**

Technical Field

The present invention relates to electrical insulating boards, especially to an electrical insulating board for forming electronic circuit patterns thereon.

Background Technology

In electronic circuits for, for example, semiconductor integrated circuits, there is a great tendency to generate high frequencies causing increased in-circuit energy loss. Therefore, for such an electronic circuit, forming circuit patterns on a substrate that is made of electrically insulating materials has reduced the energy loss. Thus, materials having electrical properties such as a low dielectric constant and a low dielectric loss tangent are preferred for use in such a substrate.

Such an electrical insulating board like this includes a substrate comprising a cloth substrate layer made of paper, glass, and the like, and an impregnated layer made by impregnating a cloth substrate layer with, for example, phenolic resin or epoxy resin. Onto a surface of the electrical insulating boards like this, conductive patterns made of copper foil are provided for circuit patterns.

In such electronic circuits, an impregnated layer having a low dielectric property is interposed between adjacent wires, so the adjacent wires become electrically insulated and in-circuit energy loss can be controlled low.

Now, fluororesins such as polytetrafluoroethylene (hereinafter referred to as PTFE) have an extremely low dielectric constant and dielectric loss tangent compared to those of other polymer materials. So it is believed that using them for an impregnated layer can lower the dielectric properties of electrical insulating boards.

On the other hand, in electrical insulating boards composed of a cloth substrate and a filled-layer of a cloth substrate (including above mentioned impregnated layer), it is known that if the impregnated material has a stick shape, for example, fibrous one, the dielectric constant of the electrical insulating board is calculated from the following equation.

<Equation 1>

$$\varepsilon_\infty = \varepsilon_1 + \phi(\varepsilon_2 - \varepsilon_1)$$

, wherein $\varepsilon_\infty$ means the dielectric constant of an electrical insulating board, $\varepsilon_1$ the dielectric constant of a cloth substrate, $\varepsilon_2$ the dielectric constant of a filler material, and $\phi$ the volume filling rate of a filler material.

According to this equation, it is suggested that the smaller the dielectric constant of a filler material filled into a cloth substrate, epsilon.sub.2, is, the lower the dielectric constant of whole substrate, epsilon.sub.infinity, is, resulting in providing a substrate excellent in electrical insulation. Therefore, this equation clearly shows that in above-mentioned electrical insulating board using fluororesin for a filled-layer, the dielectric constant of an entire insulating board, epsilon.sub.infinity, becomes low because the dielectric constant of fluororesin, epsilon.sub.2, is small.

Besides their properties including a low dielectric constant, fluororesins such as PTFE can be fashioned into variety of shapes, which may affect dielectric properties, for example, into fibrous shape by changing production methods. Further, fluororesins can be suitable for an impregnated layer and a cloth substrate by adapting its shape.

The object of the present invention is to provide an electrical insulating board excellent in electrical insulation for the one using fluororesin fibers.

Disclosure of the Invention

An electrical insulating board according to claim 1 comprises a cloth substrate and web layers. The web layers are made of fluororesin fibers stacked on and entangled with both sides of the cloth substrate forming into layers. In addition, to at least one side surface of either web layer, heat treatment at a temperature of melting point of fluororesin fiber or more is applied under pressure.

Fluororesin fiber has such properties as a low dielectric constant and a low dielectric loss tangent as well as capability of being formed into layers on a cloth substrate with increased fill ratio while leaving gaps in web layers by applying, for example, heat and pressure. Thus, the present inventors' study resulted in finding that an electrical insulating board having a low dielectric constant can be provided by adapting these characters. In addition, it has been demonstrated by above-mentioned equation.

Accordingly, the present electrical insulating board is designed to decrease such properties as the dielectric constant of an entire insulating board by building up fluororesin fibers as web layers onto the surfaces of a cloth substrate and then applying heat and pressure.

Further, since web layers in the present electrical insulating board are subjected to heat and pressure, the free contraction of fibers during thermal fusion of fibers is less occur than those subjected to heat but pressure. Thus, bond between a cloth substrate and each web layer becomes stronger and the smoothness of the outer surfaces will improve.

An electrical insulating board according to claim 2 provides a branched structure to fluororesin fibers in an electrical insulating board according to claim 1.

Processing fluororesin by a certain method provides fibers having a highly branched structure. Such a fluororesin fiber is used here for web layers for an electrical insulating board so as to lower the dielectric constant and the like.

An electrical insulating board according to claim 3 uses semi-burnt PTFE instead of fluororesin fibers in electrical insulating board according to claim 1.

The present inventors have already reported a PTFE's character that subjected to semi-burning, it produces a large amount of fibers with a branched structure. By using, especially to, such PTFE fibers for web layers in an electrical insulating board here, properties such as the dielectric constant of an electrical insulating board are intended to be lowered.

In an electrical insulating board according to claim 4, fluororesin fibers in an electrical insulating board according to claim 1 are modified by comonomer.

Comonomer-modified fluororesin fiber such as PTFE has a lower viscosity during melting than that of homopolymer PTFE, which does not contain comonomer, thereby it is easy to control the level of adhesion of fibers to each other and the range of the void ratio of web layers. Therefore, comonomer-modified fluororesin fiber is used here for web layers so as to lower, for example, the dielectric constant of an electrical insulating board especially to this kind.

In an electrical insulating board according to claim 5, the void ratio of web layers for use in an electrical insulating board according to claim 1, is from 5% to 50%.

Since PTFE has an extremely high viscosity during melting and that permits gaps to remain in fibers, heat and pressure processing can provide web layers with porous structure having defined void ratio. While a web layer for use here has a void ratio of from 5 to 50%, a high void ratio is preferred because a low dielectric constant will be provided.

In an electrical insulating board according to claim 6, fluororesin fiber employed in an electrical insulating board according to claim 1 is fiber made of ethylene-tetrafluoroethylene copolymer (hereinafter referred to as ETFE).

The present inventors have found that ETFE fiber is suitable for use in web layers for an electrical insulating board since ETFE fiber, likewise PTFE fiber, has such good properties as a low dielectric constant and a low dielectric loss tangent, and further it shows an excellent fusion bonding not only among fibers but also between fibers and the cloth substrate because it is a thermoplastic resin.

Therefore, the present electrical insulating board uses ETFE fibers for web layers to maintain the dielectric constant of an electrical insulating board low.

Additionally, an electrical insulating board according to the present invention may be the one using the mixture of ETFE fibers and PTFE fibers for web layers.

In electrical insulating board according to claim 7, a cloth substrate used in an electrical insulating board according to claim 1 is woven fiberglass.

Glass woven cloth is a preferred material for a cloth substrate in respect of its dimensional stability for the substrate due to a low coefficient of thermal expansion. Glass woven cloth is preferably used here for, especially to, a cloth substrate in an electrical insulating board to maintain, for example, the dielectric constant low.

An electrical insulating board according to claim 8 provides p-aramid fibers for a cloth substrate used in an electrical insulating board according to claim 1.

P-aramid fiber is a preferred material for a substrate because of its lower dielectric constant and higher heat-resistance than those of glass woven cloth. Therefore, P-aramid fibers are used here for a cloth substrate for, especially to, such an electrical insulating board like this to maintain, for example, the dielectric constant low.

An electrical insulating board according to claim 9 provides plain-woven cloth for a cloth substrate in an electrical insulating board according to claim 7.

Plain-woven cloth is preferred for use in a cloth substrate as material because it is thinner than the other type of woven cloth and a uniform cloth substrate can be obtained easily. Therefore, a plain-woven cloth is used here for a cloth substrate in, especially to, such an electrical insulating board like this to maintain, for example, the dielectric constant low.

An electrical insulating board according to claim 10 further provides a resin layer onto at least one side surface of web layers used in an electrical insulating board according to claim 1

It is difficult to directly adhere a conductor onto a web layer during forming circuit patterns on an electrical insulating board in respect of, for example, adherence between the web layer and the conductor. Accordingly, the method of interlaying a resin layer between a web layer and, for example, a copper foil is often employed so as to improve adhesion between the web layer and the conductor.

Therefore, the present electrical insulating board forms a resin layer on the side surface of a web layer to improve adhesion between circuit patterns and the web layer, and maintain, for example, the dielectric constant low for, especially to, such electrical insulating boards like this. In addition, the resin layer is preferably a fluororesin film, more preferably a film made from pezfluorovinyl ether-modified PTFE in respect of its excellence in thermal fusion bonding.

The form of a resin layer stacked on the surface of a web layer can be such as continuous or solid.

An electrical insulating board according to claim 11 is formed in layers using at least two electrical insulating boards for use in claim 1.

This electrical insulating board has a multilayered-structure, so modulus perpendicular to lamination is increased. Therefore, this insulating board is particularly suitable for technological fields requiring a substrate with high modulus. If used in such a field, this insulating board can be designed to maintain low dielectric constant.

The method of producing an electrical insulating board according to claim 12 comprises the first, the second, and the third steps. The first step is producing fluororesin fibers from fluororesin. The second step is adhering web layers made of fluororesin fibers onto both sides of a cloth substrate by entangling so as to form a multilayer. The third step is subjecting at least one side surface of the web layers to heat treatment at a temperature of melting point of fluororesin fiber or more under pressure.

In this manner, an electrical insulating board having properties such as low dielectric constant can be obtained, because web layers are formed of fluororesin fibers, and fluororesin fibers can be stacked on a cloth substrate with increased fill ratio by subjecting the fibers to such treatments as heat and pressure.

Further, since a web layer is subjected to heat and pressure, the free contraction of fibers during thermal fusion of fibers is less occur than those subjected to heat but pressure. Thus web layers are adhered to the cloth substrate strongly and its smoothness will improve.

The method of producing an electrical insulating board according to claim 13 further comprises the fourth step of, in addition to the method of claim 12, finishing a top surface of at least one side of the web layers by fusion bonding of a film of vinyl ether-modified PTFE there.

This method provides such advantages that the surface of an electrical insulating board becomes smoother by applying top finish to the surface of a web layer, thus problems associated with subsequent formation of conductive patterns and etching can be decreased.

An electrical insulating board according to claim 14 comprises a web layer and a thermosetting resin. The web layer is formed of PTFE fibers having a branched structure in sheet form by pressure molding. Thermosetting resin is impregnated into a web layer, accumulated, and cured.

The present inventors' study resulted in finding that once being processed in sheet form, PTFE fibers having a low dielectric constant and a branched structure, can be used for a base layer for an electrical insulating board, and further if such a sheet-formed PTFE fiber is used as a base layer, the dielectric constant of an electrical insulating board can be controlled low by using a thermosetting resin for a filled-layer.

And, it is known that the dielectric constant of an entire electrical insulating board like this is calculated from the following formula.

<Equation 1>

$$\varepsilon_\infty = \varepsilon_1 + \phi(\varepsilon_2 - \varepsilon_1)$$

, wherein $\varepsilon_\infty$ means the dielectric constant of an electrical insulating board, $\varepsilon_1$ the dielectric constant of a cloth substrate, $\varepsilon_2$ the dielectric constant of a filler material, and $\phi$ the volume filling rate of a filler material.

From this equation, it is believed if the dielectric constant of a web layer is low, if the dielectric constant of a filled-layer is higher than that of the web layer, and further if a filler material is filled in a, for example, islands-sea structure or continuous form, the dielectric constant of the entire electrical insulating board can be controlled low, thereby it becomes apparent that the dielectric constant of an electrical insulating board according to the present will also be controlled low.

Therefore, the present electrical insulating board is designed to control such properties as the dielectric constant of an entire insulating board low by using PTFE fibers having a low dielectric constant, for a cloth substrate (herein, web layer) and using a thermosetting resin having a high dielectric constant compared to PTFE fiber, for a filled-layer (herein, a layer of a thermosetting resin impregnated in a web layer), while impregnating the web layer with the fhermosetting resin into a islands-sea structure or continuous form.

An electrical insulating board according to claim 15 comprises a web layer and a thermosetting resin. The web layer is formed of the fibrous mixture of PTFE fibers having a branched structure and glass fibers, in sheet form by pressure molding. The thermosetting resin is impregnated into the web layer, accumulated, and cured.

Since glass fiber has the low coefficient of thermal expansion, the mixture of glass fibers and PTFE fibers tends to less thermally contract.

Therefore, the low dielectricity of the web layer is maintained here while the thermal contraction is controlled by mixing PTFE fibers with glass fibers.

A prepreg multilayer according to claim 16 comprises first and second prepregs. The first prepreg comprises at least one electrical insulating board according to claim 14. The second prepreg comprises at least one prepreg that is composed of a cloth substrate layer and a thermosetting resin, wherein the cloth substrate layer is made of woven fiberglass, and the thermosetting resin is impregnated in the cloth substrate layer, accumulated and cured. The first and the second prepregs are arranged alternately and laminated one after another.

This prepreg multilayer uses a low dielectric PTFE, so there will be a growing interest to apply this invention in many fields where good electrical insulation properties are required.

An electrical insulating board according to claim 17 comprises a web layer and a thermosetting resin. The web layer is formed of the fiberous mixture of PTFE fibers having a branched structure and p-aramid fibers, in sheet form by pressure molding. The thermosetting resin is impregnated in the web layer, accumulated, and cured.

Since p-aramid fiber has a low dielectric constant and a high heat-resistance, by mixing PTFE fibers and p-aramid fibers increases its heat-resistance. Thus, mixing PTFE fibers and p-aramid fibers results in maintaining the dielectricity of the web layer low while improving its heat-resistance.

In an electrical insulating board according to claim 18, PTFE fibers, which is used in an electrical insulating board according to claim 14, are subjected to semi-burning.

Subjecting PTFE to semi-burning to enhance branched structure if it has been made into fibrous. Properties such as the dielectric constant of an electrical insulating board is targeted to maintain low here by using, especially to, such PTFE fiber like this.

In an electrical insulating board according to claim 19, a thermosetting resin which is used in an electrical insulating board according to claim 14 is either of epoxy resin paints, polyimide resin paints or fluororesin paints.

Since these paints are low dielectric, using such paint for a filled-layer promotes dielectric constant of an electrical insulating board low.

Therefore, this electrical insulating board is designed to control the dielectric constant of an entire electrical insulating board low by impregnating and accumulating paint like this into a web layer and curing it in addition to using PTFE fibers.

A method of producing an electrical insulating board according to claim 20 comprises the first, the second and the third steps. The first step produces fluororesin fibers from fluororesin. The second step forms a web layer from fibers including at least fluororesin fibers in sheet form by pressure molding. The third step is having a thermosetting resin impregnated in the web layer, accumulated and cured.

According to this method, an electrical insulating board having properties such as a low dielectric constant can be provided by forming a sheet of a web layer with using low dielectric fluororesin fibers, and impregnating the web layer with a thermosetting resin.

A production method of a prepreg multilayer according to claim 21 comprises the first, the second, and the third steps. In the first step, at least one first prepreg is obtained with using an electrical insulating board according to claim 14. In the second step, at least one second prepreg is formed by impregnating a cloth substrate layer made of woven fiberglass with a thermosetting resin and stacking them. In the third step, the first prepregs and the second prepregs are arranged alternately and laminated one after another.

According to this method, the resulting prepreg multilayer becomes low dielectric as a whole by stacking the first prepregs, which is produced using low dielectric PTFE, and the second prepregs alternately. Therefore, there will be a growing interest to apply this invention in many fields where good electrical insulation properties are required.

Brief Description of the Drawings

Figure 1 is a longitudinal sectional view of an electrical insulating board according to the first embodiment of the present invention.

Figure 2 is a longitudinal sectional view of an electrical insulating board according to the second embodiment of the present invention.

Figure 3 is a longitudinal sectional view of a prepreg multilayer according to the third embodiment of the present invention.

Figure 4 is a longitudinal sectional view of an electrical insulating board according to another embodiment of the present invention.

Most Preferred Embodiment to Realize the Invention

[The First Embodiment]

Electric Insulating Board

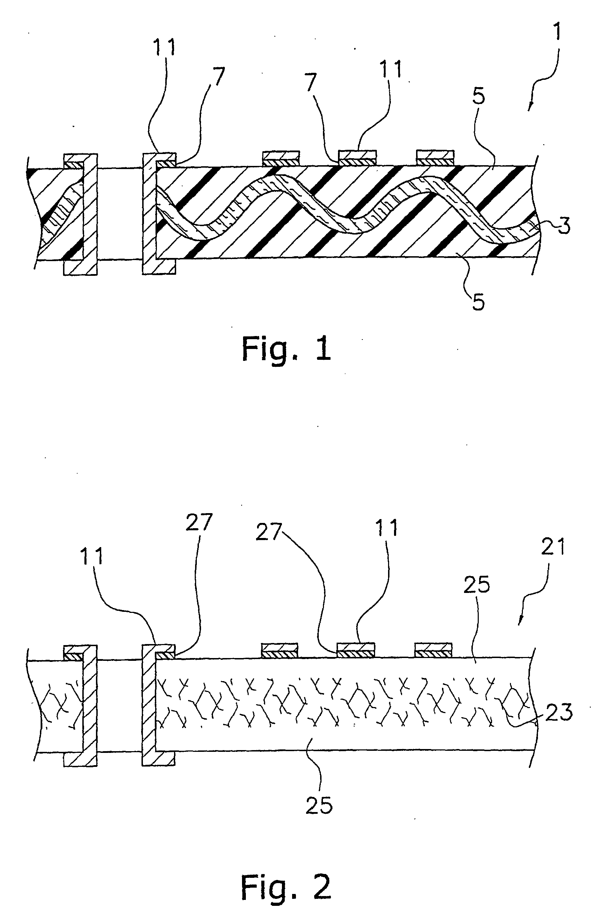

Figure 1 shows an electrical insulating board 1 employed in a particular embodiment of the present invention.

This electrical insulating board 1 comprises a cloth substrate 3, web layers 5, and a resin layer 7.

A cloth substrate 3 is a two-ply glass plain-woven cloth. A Grade E cloth substrate classified by JIS (Japan Industrial Standards) is used here because of its uniformlly thin thickness.

As a cloth substrate 3, the one made of p-aramid fibers may be used instead of a glass two-ply woven cloth. Because p-aramid fiber has a low dielectric constant and a high heat-resistance compared to a two-ply glass woven cloth.

Web layers 5 are formed of assemblages of PTFE fibers (staple fiber) having a branched structure such as branches and loops by pressure molding, and stacked on and adhered to both sides of a cloth substrate 3 by entangling. PTFE, which is a potential material of staple fiber, produces a substantial amount of staple fiber having a branched structure, and semi-burnt one is preferably used. As a method of entangling fibers, well-known methods, such as water-jet needling and needle punching can be served.

To the surface of web layers 5, heat treatment at a temperature of melting point of fluororesin fiber or more is applied under pressure. This treatment increases the fill ratio of staple fibers to a cloth substrate 3 while remaining web layers 5 with a defined void ratio.

While the void ratio of web layers 5 here is set at in the range of between 5% and 50%, this value is calculated from dividing the difference between the specific gravity 2.1 of PTFE and the specific gravity of web layers 5 with the specific gravity 2.1 of PTFE. For example, if the specific gravity of web layers is 2.1, the void ratio of the web layers results in O%. As web layers 5, staple fibers obtained from ETFE instead of PTFE may also be used because ETFE can provide the same form of a fiber as staple fiber made of PTFE. In addition, PTFE may be modified by comonomer.

A resin layer 7 is placed in order to enhance adhesion between copper foils 11, which form circuit patterns, and a web layer 5, onto the surface of a web layer 5. Resins used for a resin layer 7 include such paints as epoxy resin, polyimide resin, and fluororesin; and films of tetrafluoroethylene-hexafluoropropylene copolymer (herein after referred to as FEP), and perfluorovinyl ether-tetrafluoroethylene copolymer (perfluorovinyl ether-modified PTFE, herein after referred to as PFA). Among these resins, a fluororesin paint is preferred and PFA is more preferred. PFA can be obtained by polymerizing pertluorovinyl ether as comonomer with tetrafluoroethylene.

If there is a method such as to directly adhere copper foils 11 to a web layer 5, a resin layer 7 is dispensable.

The Method of Producing an Electric Insulating Board

The production method of this electrical insulating board 1 comprises the first, the second, the third, and the fourth steps.

In the first step, PTFE staple fibers are produced from PTFE.

The production methods of staple fibers is as follows: the method comprising obtaining tetrafluoroethylene (TFE) by emulsification and polymerization, emulsion-spinning the resulting aqueous dispersion, and then burning the obtained; the method comprising burning, drawing and then, for example, scratching a PTFE film; and the method comprising burning, drawing, splitting, and cutting a PTFE film.

As the production method of staple fibers, the method providing, for example, branches and loops to staple fibers is preferred because staple fibers having branches and loops are excellent in entangling and difficult in dehairing. Namely, the method of burning or semi-burning; drawing; and scratching a PTFE film using a high speed spinning "spike roller", and then unraveling the obtained is preferred.

Further, the production method of staple fibers preferably comprises semi-burning step of PTFE film. That is because, staple fibers having a high draw ratio (three to six times the ratio of burned one), and a low specific gravity can be obtained, thus the basis weight of fiber to web layers 5 can be lowered. In addition, since staple fibers tend to be self-adhesive, a smooth product can be obtained easily by controlling fuzz by hot plate processing.

In the second step, web layers 5 made of PTFE staple fibers are stacked on both sides of a cloth substrate 3 and adhered there by entangling. As a method of entangling fibers, well-known methods, such as water-jet needling and needle punching can be served. In the third step, at least one side surface of the web layers is subjected to heat treatment at a temperature of melting point of staple fiber or more under pressure. The temperature here is preferably at 330.degree. C or more, and more preferably 350 to 380.degree. C. Required pressure is preferably 0.01 Mpa to 5 Mpa.

In the fourth step, a vinyl ether-modified PTFE film is fusion bonded to the surface of a web layer 5 for finishing. As the method of stacking the layer, there is such as Heat Press, or sandwitching layers with hot plates and press.

An electrical insulating board 1 made in this manner is provided with good properties such as a low dielectric constant and a low dielectric tangent because low dielectric PTFE staple fibers are used for web layers 5, the web layers 5 is provided with high fill ratio by pressure molding, and gaps are remained in the web layers 5. Thus, it can effectively control the generation of in-circuit energy loss. Gaps remained in web layers 5 contribute to lower the dielectric constant because the dielectric constant of these gaps, whose void ratio to web layers 5 in these embodiments is from 5% to 50%, can be regarded as air's dielectric constant, thus the higher the void ratio is, the lower the dielectric properties of the entire electrical insulating board 1 is.

In addition, heat treatment at a temperature of the melting point of PTFE or more is applied to the surface of web layers 5 under pressure, which means fibers are thermally fixed, and therefore, the adhesion among fibers themselves and between fibers and a cloth substrate becomes stronger and highly smooth surfaces can be achieved.

[The Second Embodiment]

Electric insulating board

Figure 2 shows the electrical insulating board 21 employed in the second embodiment according to the present.

This electrical insulating board 21 comprises a web layer 23, a thermosetting resin 25, and a resin layer 27.

Though a web layer 23 is similar to the first embodiment, in this embodiment, PTFE staple fibers are formed in sheet form by pressure molding and has the same role as a cloth substrate 3 according to the first embodiment.

In addition, a web layer 23 may be composed of either PTFE staple fibers alone, or the mixture of PTFE staple fibers and glass fibers (preferably, chopped glass). This is because if a web layer 23 is composed of PTFE staple fibers alone, it tends to invite thermal contraction by heating. In addition, a web layer 23 may be composed of the mixture of PTFE staple fibers and p-aramid fibers. This is because p-aramid fiber has a low dielectric constant and a high heat-resistance compared to glass woven cloth, so in a web layer 23, the dielectricity of the mixture is controlled low and the heat-resistance is improved compared to that from PTFE staple fibers alone.

A thermosetting resin 25 is a layer accumulated by impregnation into a web layer 23, and after accumulated, cured. The preferred thermosetting resin 25 for use in the present embodiments is either of epoxy resin varnish, polyimide resin varnish, and fluororesin varnish.

A resin layer 7 is the same as the one described in the first embodiment.

The Method of Producing an Electric Insulating Board

The production method of this electrical insulating board 21 comprises the first, the second, and the third steps.

The first step is the same as the one described in the first embodiment.

In the second step, a web layer 23 is formed of PTFE staple fibers alone, or the mixture of PTFE staple fibers and either glass fibers or p-aramid fibers, in sheet form by moderate pressure molding. As the method of pressure molding, for example, "roll nip" is workable, and when employing the roll nip method, the pressure to apply is preferred to set at 0.01 Mpa to 1 Mpa.

In the third step, a thermosetting resin 25 is impregnated into a web layer 23, accumulated, and cured. For impregnation and curing, a widely known method has been employed here.

[Third Embodiment]

Prepreg Multilayer

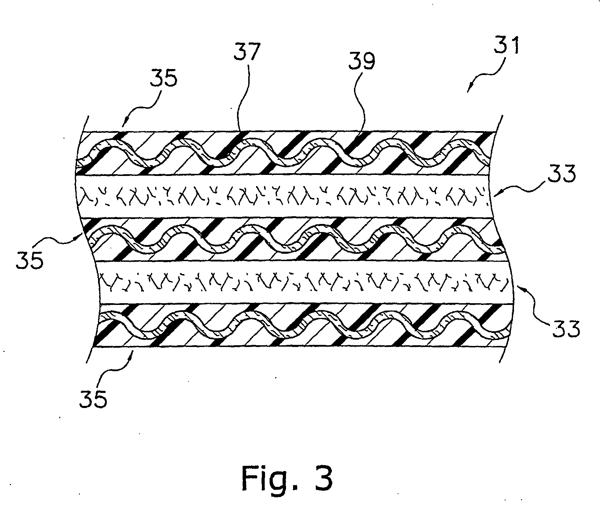

Figure 3 shows a prepreg multilayer 31 employed in an embodiment of the present invention.

This prepreg multilayer 31 comprises first prepregs 33 and second prepregs 35.

First prepregs 33 are sheet members composed in a manner similar to the electrical insulating board 21 in the second embodiment, and used in plural, two layers here.

Second prepregs 35 are sheet members each of which comprising a cloth substrate layer 37 made of woven fiberglass and a thermosetting resin 39 which is impregnated in the cloth substrate layers 37 and accumulated, and used in plural, three layers here. The second prepregs 35 are arranged between a plural number of the first prepregs 33, where each surface of the second prepregs is contacted with the adjacent first prepreg, and laminated into a stack.

Production Method of Prepreg Multilayer

This production method of a prepreg multilayer 31 comprises the first, the second, and the third steps.

In the first step, first prepregs 33 are produced in the same manner as an electrical insulating board 21 according to the second embodiment.

In the second step, second prepregs 35 are produced by impregnating a cloth substrate layer made of woven fiberglass 37 with a thermosetting resin 39 and forming a multilayer.

In the third step, the first prepregs 33 and the second prepregs 35 are arranged alternately and laminated one after another.

One laminating method of both prepregs 33 and 35 is Heat Press, or sandwitching layers with hot plates and press.

[Other Embodiments]

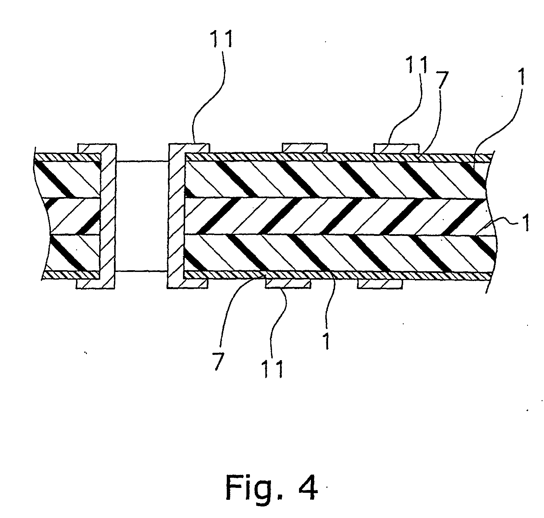

(a) Copper foils 11 maybe applied to both sides of an electrical insulating board.
(b) In the first embodiment, heat and pressure may be applied only to at least one side surface of web layers 5 where copper foils 11 are adhered.
(c) An electrical insulating board may have amultilayered-structure formed with more than one layer as shown in FIG. 4.

Industrial Applicability

The fill ratio of an electrical insulating board according to the present invention, is raised by arranging fluororesin fibers made from low dielectric fluororesin compared to the cloth substrate, on a side where circuit patterns are to be created, and applying heating and pressure to the fluororesin fibers. Therefore, the properties such as dielectric constant of an entire electrical insulating board, can be maintained low and also generation of in-circuit energy loss controlled.

**Claims**

1. An electrical insulating board comprising:

   a cloth substrate; and
   web layers made of fluororesin fibers, stacked on both sides of said cloth substrate and bonded by entangling;

   wherein to at least one side surface of said web layers, heat treatment at melting point or more of said fluororesin fiber is applied under pressure.

2. An electrical insulating board according to claim 1, wherein said fluororesin fiber has a branched structure.

3. An electrical insulating board according to claim 1, wherein said fluororesin fibers are fibers made by semi-burning polytetrafluoroethylene.

4. An electrical insulating board according to claim 1, wherein said fluororesin fibers are modified by comonomer.

5. An electrical insulating board according to claim 1, wherein said web layer has a void ratio of from 5% to 50%.

6. An electrical insulating board according to claim 1, wherein said fluororesin fibers are fibers made of ethylene-tetrafluoroethylene copolymer.

7. An electrical insulating board according to claim 1, wherein said cloth substrate is woven fiberglass.

8. An electrical insulating board according to claim 1, wherein said cloth substrate is formed of p-aramid fibers.

9. An electrical insulating board according to claim 7, wherein said cloth substrate is plain-woven cloth.

10. An electrical insulating board according to claim 1, wherein a resin layer is further formed on said at least one side surface of said web layers.

11. An electrical insulating board formed by stacking at least two said electrical insulating boards according to claim 1.

12. A method of producing an electrical insulating board comprising:

    a first step of producing fluororesin fibers from fluororesin;
    a second step of stacking web layers made of said fluororesin fibers on both sides of a cloth substrate and adhering by entangling; and
    a third step of applying heat treatment at melting point or more of said fluororesin fiber under pressure to at least one side surface of said web layers.

13. A method of producing an electrical insulating board according to claim 12, further comprising a fourth step of finishing surface by fusion bonding a film made of vinyl ether-modified polytetrafluoroethylene to at least one side surface of said web layers.

14. An electrical insulating board comprising:

a web layer formed of polytetrafluoroethylene fibers having a branched structure in sheet form by pressure molding; and
a thermosetting resin to be impregnated in said web layer, accumulated, and cured.

15. An electrical insulating board comprising:

    a web layer formed of a fibrous mixture of polytetrafluoroethylene fibers having a branched structure and glass fibers in sheet form by pressure molding; and
    a thermosetting resin to be impregnated in said web layer, accumulated, and cured.

16. A prepreg multilayer comprising:

    at least one first prepreg comprising an electrical insulating board according to claim 14; and
    at least one second prepreg comprising a cloth substrate layer made of woven fiberglass, and a thermosetting resin to be impregnated in said cloth substrate layer, accumulated, and cured;

wherein said first prepreg and said second prepreg are arranged alternately and laminated one after another.

17. An electrical insulating board comprising:

    a web layer formed of a fibrous mixture of polytetrafluoroethylene fibers having a branched structure and p-aramid fibers in sheet form by pressure molding; and
    a thermosetting resin to be impregnated in said web layer, accumulated, and cured.

18. An electrical insulating board according to claim 14, wherein said polytetrafluoroethylene fibers are fibers made by semi-burning polytetrafluoroethylene.

19. An electrical insulating board according to claim 14, wherein said thermosetting resin is either of epoxy resin paints, polyimide resin paints, or fluororesin paints.

20. A method of producing an electrical insulating board comprising:

    a first step of producing fluororesin fibers from fluororesin;
    a second step of forming a web layer from fibers including at least a partial amount of said fluororesin fibers in sheet form by pressure molding; and
    a third step of having a thermosetting resin impregnated in said web layer, accumulated and cured.

**21.** A production method of prepreg multilayer comprising:

a first step of obtaining at least one first prepreg using an electrical insulating board according to claim 14;
a second step of producing at least one second prepreg by impregnating accumulating a thermosetting resin into a cloth substrate made of woven fiberglass; and
a third step of arranging said first prepreg and said second prepreg alternately and laminating them one after another.

Fig. 1

Fig. 2

Fig. 3

Fig. 4

<table>
<tr><td colspan="2" align="center"><strong>INTERNATIONAL SEARCH REPORT</strong></td><td>International application No.<br>PCT/JP01/10290</td></tr>
</table>

| A. CLASSIFICATION OF SUBJECT MATTER |
|---|
| Int.Cl$^7$  H01B17/60, B32B5/28, H01L23/14 |
| According to International Patent Classification (IPC) or to both national classification and IPC |

| B. FIELDS SEARCHED |
|---|
| Minimum documentation searched (classification system followed by classification symbols)<br>    Int.Cl$^7$  H01B17/60, B32B5/28, H01L23/14 |
| Documentation searched other than minimum documentation to the extent that such documents are included in the fields searched<br>    Jitsuyo Shinan Koho          1926-1996     Toroku Jitsuyo Shinan Koho  1994-2002<br>    Kokai Jitsuyo Shinan Koho   1971-2002     Jitsuyo Shinan Toroku Koho  1996-2002 |
| Electronic data base consulted during the international search (name of data base and, where practicable, search terms used) |

C. DOCUMENTS CONSIDERED TO BE RELEVANT

| Category* | Citation of document, with indication, where appropriate, of the relevant passages | Relevant to claim No. |
|---|---|---|
| A | JP 6-91817 A (Toray Industries, Inc.),<br>05 April, 1994 (05.04.1994),<br>Claims    (Family: none) | 1-13 |
| X<br>Y<br>A | JP 1-139629 A (Sumitomo Bakelite Company, Limited),<br>01 June, 1989 (01.06.1989),<br>Claims; page 2, upper left column, line 12 to page 3,<br>upper right column, line 13    (Family: none) | 14-16,19-20<br>15,19<br>17-18,21 |
| X<br>Y<br>A | JP 62-163211 A (Asahi Glass Co., Ltd.),<br>20 July, 1987 (20.07.1987),<br>Claims; page 4, lower right column, line 11 to page 6,<br>lower left column, line 16    (Family: none) | 14,20<br>19<br>15-18,21 |
| X<br>Y<br>A | JP 63-69106 A (Matsushita Electric Works, Ltd.),<br>29 March, 1988 (29.03.1988),<br>Claims; page 2, upper left column, line 3 to page 3,<br>upper right column, line 10    (Family: none) | 14,19-20<br>15<br>16-18,21 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>    19 February, 2002 (19.02.02) | Date of mailing of the international search report<br>    05 March, 2002 (05.03.02) |
|---|---|
| Name and mailing address of the ISA/<br>    Japanese Patent Office | Authorized officer |
| Facsimile No. | Telephone No. |

Form PCT/ISA/210 (second sheet) (July 1992)

**INTERNATIONAL SEARCH REPORT**

International application No.

PCT/JP01/10290

| C (Continuation). DOCUMENTS CONSIDERED TO BE RELEVANT | | |
|---|---|---|
| Category* | Citation of document, with indication, where appropriate, of the relevant passages | Relevant to claim No. |
| X<br>Y<br>A | JP 11-150344 A (Hitachi Cable, Ltd.),<br>02 June, 1999 (02.06.1999),<br>Claims; page 3, right column, line 1 to page 5, right column,<br>line 6 (Family: none) | 14,20<br>15,19<br>16-18,21 |
| A | JP 5-69442 A (Nitto Denko Corporation),<br>23 March, 1993 (23.03.1993),<br>Claims (Family: none) | 1-21 |
| A | JP 4-103312 A (Hitachi Chemical Co., Ltd.),<br>06 April, 1992 (06.04.1992),<br>Claims (Family: none) | 1-21 |

Form PCT/ISA/210 (continuation of second sheet) (July 1992)

## INTERNATIONAL SEARCH REPORT

International application No.

PCT/JP01/10290

**Box I   Observations where certain claims were found unsearchable (Continuation of item 1 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box II   Observations where unity of invention is lacking (Continuation of item 2 of first sheet)**

This International Searching Authority found multiple inventions in this international application, as follows:

Claims 1 to 13 are so linked as to form a single general inventive concept with the technical feature of an electrical insulating plate which has a base cloth and a web layer comprising a fluororesin fiber being joined by entanglement with the base cloth and laminated on both the surfaces of the base cloth, wherein at least one surface of the web layer has been subjected to a heat treatment at the melting temperature of the fluororesin fiber or higher under pressure. On the other hand, claims 14 to 21 are so linked as to form a single general inventive concept with the technical feature of an electrical insulating plate which has a web layer comprising a fiber of a polytetrafluoroethylene having a branched structure formed under pressure into a sheet shape and a curable resin which is impregnated into and laminated on the web layer and is subjected to curing. It is clear from the above that claims 1 to 13 and claims 14 to 21 have technical features different from each other. Accordingly, this international application describes two inventions, that is, claims 1 to 13 and claims 14 to 21.

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**   ☐   The additional search fees were accompanied by the applicant's protest.

☐   No protest accompanied the payment of additional search fees.

Form PCT/ISA/210 (continuation of first sheet (1)) (July 1992)